(19) Europäisches Patentamt
European Patent Office
Office européen des brevets

(11) **EP 4 730 031 A2**

(12) **EUROPEAN PATENT APPLICATION**

(43) Date of publication:
**22.04.2026 Bulletin 2026/17**

(21) Application number: **25204920.0**

(22) Date of filing: **26.09.2025**

(51) International Patent Classification (IPC):
**G03F 1/24** (2012.01)   **G03F 1/26** (2012.01)
**G03F 1/54** (2012.01)

(52) Cooperative Patent Classification (CPC):
**G03F 1/26; G03F 1/24; G03F 1/54**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **15.10.2024 JP 2024179573**

(71) Applicant: SHIN-ETSU CHEMICAL CO., LTD.,
**Chiyoda-ku,
Tokyo 1000005 (JP)**

(72) Inventors:
• **KAWAMURA, Ryoto**
**Niigata, 9428601 (JP)**
• **SAKURAI, Keisuke**
**Niigata, 9428601 (JP)**
• **MIMURA, Shohei**
**Niigata, 9428601 (JP)**

(74) Representative: **Mewburn Ellis LLP**
**Aurora Building
Counterslip
Bristol BS1 6BX (GB)**

(54) **REFLECTIVE PHOTOMASK BLANK, AND METHOD FOR MANUFACTURING REFLECTIVE PHOTOMASK**

(57)    A reflective photomask blank including a substrate, a multilayer reflection film, a protection film and a light absorbing film that has a phase shift function is provided. The light absorbing film contains ruthenium and chromium and is free of oxygen and nitrogen, and has a ruthenium content of 64 to 74 at%, a chromium content of 26 to 36 at%, a thickness of 40 to 44 nm, and a reflectance of 12 to 15% and a phase shift of 200 to 230 degrees with respect to exposure light being light in extreme ultraviolet range.

# FIG.1

EP 4 730 031 A2

**Description**

<u>TECHNICAL FIELD</u>

The present invention relates to a method for manufacturing a reflective photomask that is used in manufacturing semiconductor devices and others, and a reflective photomask blank that is used as a material for manufacturing the reflective photomask.

<u>BACKGROUND</u>

It is required that projection exposure has high pattern resolution in accordance with miniaturization of semiconductor devices, particularly, in accordance with high integration of large-scale integrated circuits. So, as a photomask, a phase shift mask has been developed as a means for improving the resolution of a transfer pattern. A principle of phase shift method is that, by adjusting so as to invert a phase of transmitted light that has been passed through an opening of a phase shift film of a photomask by about 180 degrees with respect to a phase of transmitted light that has been passed through the portion of the phase shift film adjacent to the opening, interference between the transmitted lights reduces a light intensity at the boundary of the opening and the portion adjacent to the opening. As a result, resolution and depth of focus of a transfer pattern are improved. A photomask utilizing this principle is generally called a phase shift mask. The phase shift mask in this case is a type of transmissive photomask that transmits exposure light.

A most common phase shift mask blank, as a material for the phase shift mask, that is used for manufacturing the phase shift mask has a structure in which a phase shift film is laminated on a transparent substrate such as a glass substrate, and a film composed of a material containing chromium (Cr) is laminated on the phase shift film. The phase shift film usually has a phase shift of about 175 to 185 degrees and a transmittance of about 6 to 30% with respect to exposure light, and a mainstream phase shift film is composed of a material containing silicon (Si), particularly a material containing molybdenum (Mo) and silicon (Si). Generally, the film composed of a material containing chromium (Cr) is adjusted so as to have a thickness that provides a desired optical density together with the phase shift film, and the film composed of a material containing chromium (Cr) is provided as a light-shielding film, and is also used as an etching mask in etching the phase shift film.

As a general method for manufacturing a phase shift mask by patterning a phase shift film from a phase shift mask blank in which a phase shift film that is composed of a material containing silicon (Si), and a light-shielding film that is composed of a material containing chromium (Cr) are formed in this order on a transparent substrate, the following method is exemplified. First, a resist film is formed on the light-shielding film composed of a material containing chromium (Cr) of the phase shift mask blank, and a resist pattern is formed by drawing a pattern onto the resist film by light or an electron beam, and developing. Next, the light-shielding film composed of a material containing chromium (Cr) is dry-etched with using the resist pattern as an etching mask, and a chlorine-based gas to form a pattern of the light-shielding film. Further, the phase shift film composed of a material containing silicon (Si) is dry-etched with using the pattern of the light-shielding film as an etching mask, and a fluorine-based gas to form a pattern of the phase shift film. Then, the resist pattern is removed, and the pattern of the light-shielding film is removed by dry etching using a chlorine-based gas.

In this case, the light-shielding film is left at the portion outside the portion in which the pattern of the phase shift film (a circuit pattern) is formed, and a light-shielding portion (light-shielding pattern) having an optical density of not less than 3 in the combination of the phase shift film and the light-shielding film is formed at the outer periphery portion of the phase shift mask. This is to prevent irradiation of exposure light caused by leaking the exposure light at the outer periphery portion of the phase shift mask to the resist film on an adjacent chip on a wafer from the portion located outside the circuit pattern in transferring the circuit pattern to the wafer with using a wafer exposure apparatus. In a general method for forming such a light-shielding pattern, after forming the pattern of the phase shift film and removing the resist pattern, a resist film is anew formed, and a resist pattern that remains at the outer periphery portion of the light-shielding film is formed by drawing a pattern and developing. Then, the film composed of a material containing chromium (Cr) is etched with using the resist pattern as an etching mask to left the light-shielding film at the outer periphery portion of the phase shift mask.

A mainstream etching in a phase shift mask blank that requires pattern formation with highly accurate is dry etching using gas plasma. Dry etching using a chlorine-based gas (chlorine-based dry etching) is used as dry etching for a film composed of a material containing chromium (Cr), and dry etching using a fluorine-based gas (fluorine-based dry etching) is used as dry etching for a film containing silicon (Si) and a film containing molybdenum and silicon. Particularly, it is known that, in dry etching for a film composed of a material containing chromium (Cr), chemical reactivity and etching rate are increased by applying an etching gas of chlorine gas ($Cl_2$ gas) mixed with 10 to 25 vol% of oxygen gas ($O_2$ gas) as an etching gas.

According to miniaturization of circuit patterns, a circuit pattern of the phase shift mask also requires a technique for fine pattern formation. Particularly, assist patterns of line patterns, which assist resolution of main patterns of the phase shift mask, are needed to be formed smaller than the main patterns so as not to be transferred to a wafer when circuit patterns are transferred to the wafer with using a wafer exposure apparatus. In a phase shift mask of a generation in which a half pitch of line and space patterns on the wafer is 10 nm, a line width for the assist patterns of the line patterns in a circuit on the phase shift mask is required to be about 40 nm.

A chemically amplified resist, which can form fine patterns, consists of a base resin, an acid generator, a surfactant and others, and can be applied to many reactions in which the acid generated by exposure acts as a catalyst. Thus, the chemically amplified resist can have high sensitivity. By using the chemically amplified resist, it possible to form a mask pattern such as a fine pattern of the phase shift film that has a line width of 0.1 μm or less. The resist is applied onto a photomask blank by spin coating using a resist coater.

Furthermore, higher pattern resolution that has been recently required for projection exposure, as a desired pattern resolution, is becoming difficult to obtain even when a transmission type phase shift mask is used. Therefore, for the logic 7 nm generation and later, EUV lithography using light in extreme ultraviolet range (EUV light) as the exposure light has come to be used.

Light in extreme ultraviolet range is easily absorbed by all materials, and transmission lithography such as conventional photolithography using ArF excimer laser light cannot be used. Therefore, a reflective optical system is used in EUV lithography. Light in extreme ultraviolet range having a wavelength of 13 to 14 nm is used in EUV lithography, while the wavelength of conventional ArF excimer laser light is 193 nm. Therefore, compared to photolithography using conventional ArF excimer laser light, the exposure wavelength is shorter, and finer patterns in a photomask can be transferred.

A photomask used in EUV lithography is a reflective photomask in which the exposure light is reflected by the photomask, and generally has a structure in which a reflection film that reflects light in extreme ultraviolet range, a protection film for protecting the reflection film, and a pattern of a light absorbing film that absorbs light in extreme ultraviolet range in this order on a substrate such as a glass substrate. As the reflection film, a multilayer reflection film in which low refractive index layers and high refractive index layers are alternately stacked so as to increase reflectance when light in extreme ultraviolet range is irradiated onto the surface of the reflection film is used. Usually, for the multilayer reflection film, a molybdenum (Mo) layer and a silicon (Si) layer are used as the low refractive index layer, and the high refractive index layer, respectively. As the protection film, a ruthenium (Ru) film is usually used. On the other hand, a material having a high absorption coefficient with respect to light in extreme ultraviolet range, in particular, a material containing, for example, chromium (Cr) or tantalum (Ta), as a main component, is used for the light absorbing film. In early-generation EUV lithography, a binary-type reflective photomask in which light was not reflected by the light absorbing film was used.

As a general method for manufacturing a reflective photomask by patterning a light absorbing film from a reflective photomask blank in which a reflection film that reflects light in extreme ultraviolet range, a protection film for protecting the reflection film, and a light absorbing film that absorbs light in extreme ultraviolet range are formed in this order on a substrate, in particular, the following method is exemplified. First, a resist film is formed on the light absorbing film, a pattern is drawn onto the resist film by light or an electron beam, and developed to form a resist pattern. Next, the light absorbing film is dry-etched with using the resist pattern as an etching mask to form a pattern of the light absorbing film, and then the resist pattern is removed.

In EUV lithography, for the logic 3 nm generation and later, a reflective photomask (reflective phase shift photomask) that includes a pattern of a light absorbing film having a phase shift function is used to form a finer pattern on a wafer. By using a reflective phase shift photomask, higher wafer transfer characteristics can be obtained compared to a binary-type reflective photomask. The wafer transfer characteristics can be expressed by NILS (Normalized Image Log Slope), which corresponds to contrast of light intensity transferred to a wafer, and the NILS can be calculated by the following expression:

$$\text{NILS}=(dI/dx)/(W \times Ith),$$

wherein W is a desired pattern dimension, Ith is a threshold of light intensity providing W, and dI/dx is a gradient of aerial image. When the NILS value is large, the optical image is steep, improving dimensional controllability of a resist pattern on the wafer. Therefore, to form a finer pattern on the wafer, a large NILS value is effective, and a reflective phase shift photomask, which can provide a larger NILS value than a binary-type reflective photomask, is used.

In addition, the phase shift film necessarily has a certain thickness or more that can provide a predetermined reflectance with absorbing a part of exposure light. However, in a reflective phase shift photomask, the exposure light is obliquely incident in the reflective photomask and is obliquely reflected. Therefore, when the phase shift film is thick, influence of shadowing effect in which the exposure light is blocked by the phase shift film when the exposure light is incident and reflected increases. Accordingly, to reduce the influence of the shadowing effect, a thinner phase shift film that provides a predetermined reflectance is advantageous.

For example, JP 2022-24617 A (Patent Document 1) disclose, as a layer of a phase shift film in a reflective mask blank for EUV lithography, a layer 1 containing ruthenium (Ru), and at least one selected from the group consisting of oxygen (O) and nitrogen (N). JP 2022-24617 A (Patent Document 1) disclose, as the layer 1, a layer containing Ru in the range of 40 to 99 at%, and O in the range of 1 to 60 at%, and further containing an element (X) such as chromium (Cr), and having a compositional ratio of Ru and X: Ru:X (at%) of 20:1 to 1:5, a total content of Ru and X of 40 to 99 at%, and an O content of 1 to 60 at%, and a layer containing Ru in the range of 30 to 98 at%, O in the range of 1 to 69 at%, and N in the range of 1 to 69 at%, and further containing an element (X) such as chromium (Cr), and having a compositional ratio of Ru and X: Ru:X (at%) of 20:1 to 1:5, a total content of Ru and X of 30 to 98 at%, and an O content of 1 to 69 at% and a N content of 1 to 69 at%.

Citation List

Patent Document 1: JP 2022-24617 A

SUMMARY OF THE INVENTION

When fine line and space patterns are formed on a wafer by using a reflective phase shift mask, a phase shift film having a reflectance with respect to exposure light that is significantly deviated from about 12.5%, or a phase shift with respect to exposure light that is significantly deviated from about 215 degrees cannot provide high wafer transfer characteristics (NILS) in line and space patterns on a wafer. Further, even when the phase shift film has a reflectance of about 12.5% with respect to exposure light and a phase shift of about 215 degrees with respect to exposure light, a thick phase shift film cannot provide sufficient contrast in light intensity due to shadowing effect.

The present invention has been made to solve the above problems. An object of the present invention is to provide a reflective photomask blank that can provide a reflective photomask including a thinner light absorbing film that has good wafer transfer characteristics (high NILS value) and is less susceptible to shadowing effect, and to provide a method for manufacturing a reflective photomask from such a reflective photomask blank.

NILS is affected by a size of the pattern on a wafer, a pitch of the pattern, and the reflectance with respect to exposure light and the phase shift with respect to exposure light of the reflective phase shift photomask. For example, in line and space patterns on a wafer, when the sizes of line and space s are each 24 nm to 36 nm, a good NILS value is obtained when the reflectance with respect to exposure light is around 12.5% and the phase shift with respect to exposure light is around 215 degrees.

With respect to a light absorbing film having a phase shift function, the inventors have made earnestly studies to solve the above problems. As a result, the inventors found that the above problems can be solved by a light absorbing film that contains ruthenium (Ru) and chromium (Cr), is free of oxygen (O) and nitrogen (N), and has a ruthenium (Ru) content of not less than 64 at% and not more than 74 at%, and a chromium (Cr) content of not less than 26 at% and not more than 36 at%, and found that, at a reflectance of around 12.5% with respect to the exposure light, the light absorbing film has a phase shift function having good wafer transfer characteristics (high NILS value) at a phase shift of around 215 degrees with respect to the exposure light, whereas the light absorbing film is thin.

In one aspect, the invention provides a reflective photomask blank including a substrate,

a multilayer reflection film that is formed on the substrate and reflects exposure light being light in extreme ultraviolet range,
a protection film that is formed on the multilayer reflection film to protect the multilayer reflection film, and
a light absorbing film that is formed on the protection film, absorbs the exposure light, and has a phase shift function, wherein

the light absorbing film
contains ruthenium (Ru) and chromium (Cr) and is free of oxygen (O) and nitrogen (N), and
has a ruthenium (Ru) content of not less than 64 at% and not more than 74 at%, and a chromium (Cr) content of not less than 26 at% and not more than 36 at%,
a thickness of not less than 40 nm and not more than 44 nm,
a reflectance of not less than 12% and not more than 15% with respect to the exposure light, and a phase shift of not less than 200 degrees and not more than 230 degrees with respect to the exposure light.

Preferably, the light absorbing film further contains niobium (Nb), and has a niobium (Nb) content of not more than 4 at%.

Preferably, the protection film has a thickness of not less than 1 nm and not more than 6 nm.

In the other aspect, the invention provides a method for manufacturing a reflective photomask including a pattern of the light absorbing film from the reflective photomask blank wherein
the method includes the steps of:

(A) forming a resist film in contact with the light absorbing film at the side remote from the substrate,

(B) patterning the resist film to form a resist pattern,

(C) patterning the light absorbing film to form a light absorbing film pattern by dry etching using a chlorine-based gas, and the resist pattern as an etching mask, and

(D) removing the resist pattern.

ADVANTAGEOUS EFFECTS

According to the invention, a reflective photomask blank that can provide a reflective photomask including a thinner light absorbing film that has good wafer transfer characteristics (high NILS value) and is less susceptible to shadowing effect can be provided. For example, a good pattern in a miniaturized line and space pattern on a wafer can be obtained.

BRIEF DESCRIPTION OF THE DRAWINGS

FIG. 1 is a cross-sectional view illustrating an example of a reflective photomask blank of the invention.
FIG. 2 is a cross-sectional view illustrating an example of a reflective photomask of the invention.

FURTHER EXPLANATIONS; OPTIONS AND PREFERENCES

A reflective photomask blank of the invention includes a substrate, a multilayer reflection film that is formed on the substrate, a protection film that is formed on the multilayer reflection film, and a light absorbing film that is formed on the protection film.

When a reflective photomask is held on a mask stage of an exposure apparatus, usually, the reflective photomask is secured by an electrostatic chuck. Therefore, the reflective photomask blank and the reflective photomask of the invention may include a conducting film (backside film) on the back surface of the substrate (the surface opposite to the front surface on which the multilayer reflection film or others are formed) for securing the reflective photomask by an electrostatic chuck. Further, the reflective photomask blank of the invention may further include a resist film formed on the light absorbing film directly or via another film.

From the reflective photomask blank of the invention, for example, a reflective photomask including a substrate, a multilayer reflection film that is formed on the substrate, a protection film that is formed on the multilayer reflection film, and a pattern (circuit pattern or photomask pattern) of a light absorbing film that is formed on the protection film can be obtained.

The structures of the reflective photomask blank and the reflective photomask of the invention are described below with reference to the drawings. In the descriptions for the drawings, identical components may be given the same reference symbols and their duplicate descriptions may be omitted. In addition, the drawings may be enlarged for convenience, and the dimensional ratio of each component may not be the same as the actual ratio.

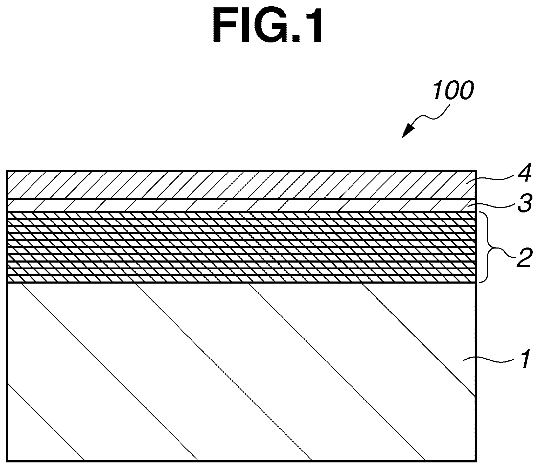

FIG. 1 is a cross-sectional view illustrating an example of a reflective photomask blank of the invention. This reflective photomask blank 100 includes a substrate 1, and on the substrate 1, a multilayer reflection film 2 that is formed in contact with the substrate 1, a protection film 3 that is formed on the multilayer reflection film 2 and in contact with the multilayer reflection film 2, and a light absorbing film 4 that is formed on the protection film 3 and in contact with the protection film 3.

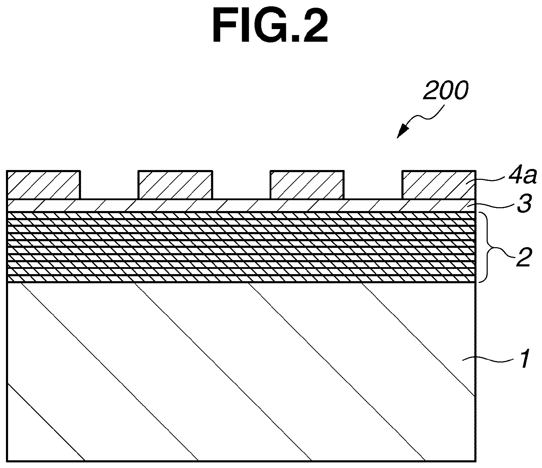

FIG. 2 is a cross-sectional view illustrating an example of a reflective photomask of the invention. This reflective photomask 200 includes, a substrate 1, and on the substrate 1, a multilayer reflection film 2 that is formed in contact with the substrate 1, a protection film 3 that is formed on the multilayer reflection film 2 and in contact with the multilayer reflection film 2, and a pattern of a light absorbing film 4a that is formed on the protection film 3 and in contact with the protection film 3.

A material or dimensions of the substrate are not particularly limited, and the substrate for the reflective photomask blank and the reflective photomask may or may not be transparent at the wavelength of exposure light. As the substrate, a glass substrate such as a quartz substrate may be used. A suitable substrate is, for example, a substrate called a 6025 substrate having dimensions of 6 inches square and 0.25 inches thick, which is defined in the SEMI standard. The 6025 substrate is generally represented a substrate having dimensions of 152 mm square and 6.35 mm thick in the SI unit system.

The multilayer reflection film is a film that reflects exposure light being light in extreme ultraviolet range. The multilayer reflection film is preferably formed in contact with the substrate. This light in extreme ultraviolet region is called EUV light, and the EUV light has a wavelength of 13 to 14 nm, and the EUV light generally has a wavelength of about 13.5 nm.

A material constituting the multilayer reflection film is preferably a material that is resistant to dry etching using a chlorine-based gas (for example, chlorine gas (Cl$_2$ gas) only, or a mixed gas of chlorine gas (Cl$_2$ gas) and oxygen gas (O$_2$ gas)) (chlorine-based dry etching).

As materials constituting the multilayer reflection film, for example, silicon (Si) and molybdenum (Mo) are exemplified. In this case, as the multilayer reflection film, a laminated film (Si/Mo laminated film) in which about 20 to 60 layers of silicon (Si) layers and molybdenum (Mo) layers are alternately laminated is generally used.

In the case that the multilayer reflection film is the laminated film (Si/Mo laminated film, the multilayer reflection film has a thickness of preferably not less than 200 nm, more preferably not less than 220 nm, and preferably not more than 340 nm, more preferably not more than 280 nm. The silicon (Si) layer has a thickness of preferably not less than 2 nm, more preferably not less than 3 nm, and preferably not more than 6 nm, more preferably not more than 5 nm. The molybdenum (Mo) layer has a thickness of preferably not less than 1 nm, more preferably not less than 2 nm, and preferably not more than 5 nm, more preferably not more than 4 nm.

Further, as materials constituting the multilayer reflection film, silicon (Si) and ruthenium (Ru) are also exemplified. In this case, as the multilayer reflection film, a laminated film (Si/Ru laminated film) in which silicon (Si) layers and ruthenium (Ru) layers are alternately laminated is generally used.

The protection film is a film to protect the multilayer reflection film. The protection film is preferably formed in contact with the multilayer reflection film. The protection film is provided to protect the multilayer reflection film, for example, during cleaning in processing into a reflective photomask, or during cleaning or correction of the reflective photomask. Further, the protection film preferably has a function of protecting the multilayer reflection film when the light absorbing film is patterned by etching, or a function of preventing oxidation of the multilayer reflection film.

A material constituting the protection film is preferably a material having etching characteristics different from that of the light absorbing film, in particular, is preferably a material that is resistant to chlorine-based dry etching. Further, the material constituting the protection film is preferably a material that is resistant to a cleaning solution containing sulfuric acid or a cleaning solution containing an alkaline.

As the material constituting the protection film, in particular, for example, a material containing ruthenium (Ru) is exemplified. The material constituting the protection film may be ruthenium (Ru) only, or a ruthenium (Ru) compound containing ruthenium (Ru), and at least one selected from the group consisting of molybdenum (Mo), niobium (Nb), zirconium (Zr), yttrium (Y), boron (B), rhodium (Rh), titanium (Ti) and lanthanum (La).

The protection film may be a single layer film or a multilayer film (for example, a film constituted with two to four layers). Further, the protection film may also be a film having a gradient composition. When the protection film is thin, the reflectance of exposure light from the multilayer reflection film of the reflective photomask is high, and in exposure using a reflective photomask, more exposure light is irradiated onto a wafer, improving productivity in exposure using a reflective photomask. On the other hand, when the protection film is too thin, the function as a protection film to protect the multilayer reflection film is lost. Therefore, the protection film has a thickness of preferably not less than 1 nm, and preferably not more than 6 nm, more preferably not more than 4 nm.

The light absorbing film is a film that absorbs exposure light being light in extreme ultraviolet range. The light absorbing film in preferably formed in contact with the protection film.

A material constituting the light absorbing film is preferably a material that can be etched by dry etching using a chlorine-based gas containing oxygen (for example, dry etching using a mixed gas of chlorine gas (Cl$_2$ gas) and oxygen gas (O$_2$ gas)).

The light absorbing film contains ruthenium (Ru) and chromium (Cr). On the other hand, the light absorbing film is free of oxygen (O) and nitrogen (N). In this case, with respect to content of oxygen (O) in the light absorbing film, an amount contained in a surface oxide layer, which is formed at the surface portion of the light absorbing film by contacting the light absorbing film with the air after the light absorbing film is formed, is allowable. During forming and just after forming the light absorbing film, the light absorbing film of the invention does not contain oxygen (O) and nitrogen (N) in an amount exceeding an amount of an impurity.

As the material constituting the light absorbing film, in particular, for example, ruthenium chromium (RuCr) is exemplified. Further, after a reflective photomask blank is processed to a reflective photomask, the light absorbing film is exposed to the air in environment for storage or environment for use in a wafer exposure apparatus. Therefore, the light absorbing film containing niobium (Nb) along with ruthenium (Ru) and chromium (Cr) is advantageous in the viewpoint of resistance to oxygen contained in the air. As the material containing niobium (Nb), in particular, for example, ruthenium chromium niobium (RuCrNb) is exemplified.

The light absorbing film has a ruthenium (Ru) content of preferably not less than 64 at%, more preferably not less than 67 at%, and preferably not more than 74 at%, more preferably not more than 71 at%. The light absorbing film has a chromium (Cr) content of preferably not less than 26 at%, more preferably not less than 29 at%, and preferably not more than 36 at%, more preferably not more than 33 at%. In the case that the light absorbing film contains niobium (Nb), the light absorbing film has a niobium (Nb) content of preferably not more than 4 at%, more preferably not more than 3 at%. In this case, the lower limit of the niobium (Nb) content is more than 0 at%, and the niobium (Nb) content is preferably not less than 1 at%, however, not particularly limited thereto.

In the invention, the light absorbing film is a film having a phase shift function, i.e., a phase shift film. A light absorbing film having a phase shift function is a film that absorbs a part of exposure light and reflects the remaining part with changing (shifting) the phase relative to the phase of the exposure light reflected from the multilayer reflection film, thereby obtaining a phase shift function due to the phase shift between the light reflected from the multilayer reflection film and the light reflected from the light absorbing film.

The reflective photomask blank and the reflective photomask of the invention can be referred to as a reflective photomask blank having a phase shift function (a reflective phase shift photomask blank) and a reflective photomask having a phase shift function (a reflective phase shift photomask), respectively. The phase shift function of the light absorbing film can improve wafer transfer characteristics (NILS).

The light absorbing film having a phase shift function (phase shift film) has a reflectance of preferably not less than 12%, more preferably not less than 13%, and preferably not more than 15%, more preferably not more than 14%, with respect to exposure light which is light in extreme ultraviolet range. The reflectance is a relative reflectance with respect to a portion where the light absorbing film is not formed. In particular, the reflectance is a ratio of the reflectance of the light reflected from the light absorbing film that is formed on the substrate via the multilayer reflection film and the protection film relative to the reflectance of the light reflected from the multilayer reflection film and the protective film that are formed on the substrate.

The light absorbing film having a phase shift function (phase shift film) has a phase shift of preferably not less than 200 degrees, more preferably not less than 205 degrees, and preferably not more than 230 degrees, more preferably not more than 225 degrees, with respect to exposure light which is light in extreme ultraviolet range. The phase shift is a relative phase shift with respect to a portion where the light absorbing film is not formed. In particular, the phase shift is a difference between the phase shift of the light reflected from the multilayer reflection film and the protective film that are formed on the substrate, and the phase shift of the light reflected from the light absorbing film that is formed on the substrate via the multilayer reflection film and the protection film.

The light absorbing film may be a single layer film or a multilayer film (for example, a film constituted with two to five layers). Further, the light absorbing film may also be a film having a gradient composition. The light absorbing film has a thickness of preferably not less than 36nm, more preferably not less than 38 nm, and preferably not more than 52 nm, more preferably not more than 50 nm, even more preferably not more than 48 nm, in the viewpoint of ensuring a light absorbing function and a phase shift function, and reducing influence of shadowing effect. Particularly, the light absorbing film has a thickness of further preferably not less than 40 nm, most preferably not less than 41 nm, and further preferably not more than 44 nm, most preferably not more than 43 nm in the viewpoint of ensuring a light absorbing function and a phase shift function and reducing shadowing effect.

The conducting film is preferably formed in contact with the substrate. The conducting film preferably has a sheet resistance of not more than 100 Ω/square, and the conducting film does not have any limitation in materials. As the material for the conducting film, for example, a material containing tantalum (Ta) or chromium (Cr) is exemplified. Further, the material containing tantalum (Ta) or chromium (Cr) may contain oxygen (O), nitrogen (N), carbon (C), boron (B) or others. The conducting film has a thickness enough to act for use in electrostatic chucking, and usually has a thickness of about 20 to 300 nm, however, not particularly limited thereto.

In the invention, an electron beam resist that is drawn with an electron beam or a photoresist that is drawn with light may be used for a resist film, and the chemically amplified resist is preferable. The chemically amplified resist may be a positive type or a negative type, and examples of the resists include a resist containing a base resin such as a hydroxystyrene-based resin or a (meth)acrylic acid-based resin, and an acid generator, and optionally containing a cross-linking agent, a quencher, a surfactant, or other components.

The resist film has a thickness of preferably not more than 150 nm. In developing step for a resist pattern, to form the resist pattern that is hard to be collapsed by impact of a development solution or impact of pure water during rinsing process, in the case of forming a fine assist pattern, the resist film has a thickness of more preferably not more than 100 nm. The resist film has a thickness as a lower limit that functions as an etching mask in etching, i.e., a thickness that can maintain a resist pattern on the entire surface of the film to be etched after etching. The lower limit is preferably not less than 50 nm, more preferably not less than 70 nm, however, not particularly limited thereto.

In the invention, the multilayer reflection film, the protection film, the light absorbing film and the conducting film are preferably formed by a sputtering method since the sputtering method has good controllability and can be easy to form a film having predetermined characteristics, however, not particularly limited thereto. As a system of the sputtering, a DC sputtering system or an RF sputtering system can be applied, however, not particularly limited thereto.

When a laminated film of molybdenum (Mo) layers and silicon (Si) layers is formed as the multilayer reflection film, a molybdenum (Mo) target and a silicon (Si) target may be used as sputtering targets. Further, when a laminated film of ruthenium (Ru) layers and silicon (Si) layers is formed as the multilayer reflection film, a ruthenium (Ru) target and a silicon (Si) target may be used as sputtering targets.

When the protection film is composed of a material containing ruthenium (Ru), a ruthenium (Ru) target may be used as a sputtering target, and a target of another element constituting the protection film may be used, if needed.

When the light absorbing film composed of a material containing ruthenium (Ru) and chromium (Cr), a ruthenium (Ru) target and a chromium (Cr) target may be used as sputtering targets. Further, in the case that the light absorbing film is composed of a material containing niobium (Nb) along with ruthenium (Ru) and chromium (Cr), a niobium (Nb) target may be used as a sputtering target.

When a conducting film is composed of a material containing tantalum (Ta) or chromium (Cr), a tantalum (Ta) target or a chromium (Cr) target may be used as a sputtering target.

A power to be supplied to the sputtering target may be appropriately set depending on dimensions of the sputtering target, cooling efficiency, controllability of film formation or others. The power is normally 50 to 3000 W/cm$^2$ as a power per area of the sputtering surface of the sputtering target. Further, as a sputtering gas, a rare gas such as helium gas (He gas), neon gas (Ne gas) and argon gas (Ar gas) may be used. When the film or the layer constituting the film that contains only the element constituting the target is formed, only the rare gas may be used as the sputtering gas.

When the film or the layer constituting the film is composed of a material containing oxygen (O), nitrogen (N) or carbon (C), the sputtering is preferably reactive sputtering. A rare gas such as helium gas (He gas), neon gas (Ne gas) and argon gas (Ar gas), and a reactive gas are used as sputtering gases for the reactive sputtering. Particularly, to form the light absorbing film containing nitrogen (N), preferably, the sputtering is reactive sputtering, and a reactive gas containing nitrogen (N) and being free of oxygen (O) is used.

When the film or the layer constituting the film is composed of a material containing nitrogen (N), nitrogen gas (N$_2$ gas) may be used as the reactive gas. When the film or the layer constituting the film is composed of a material containing oxygen (O), oxygen gas (O$_2$ gas) may be used as the reactive gas. When the film or the layer constituting the film is composed of a material containing nitrogen (N) and oxygen (O), the reactive gas may be appropriately selected and used from oxygen gas (O$_2$ gas), nitrogen gas (N$_2$ gas), and a nitrogen oxide gas such as nitrogen monoxide gas (NO gas), nitrogen dioxide gas (NO$_2$ gas) and nitrous oxide gas (N$_2$O gas). When the film or the layer constituting the film is composed of a material containing carbon, a gas containing carbon such as methane gas (CH$_4$), carbon monoxide gas (CO gas) and carbon dioxide gas (CO$_2$ gas) may be used as the reactive gas. When the film or the layer constituting the film is composed of a material containing nitrogen (N), oxygen (O) and carbon (C), for example, nitrogen gas (N$_2$ gas), oxygen gas (O$_2$ gas), and carbon dioxide gas (CO$_2$) may be used simultaneously.

A pressure in forming the film or layer constituting the film may be appropriately set in consideration of film stress, chemical resistance, cleaning resistance or others. Particularly, chemical resistance is improved by setting the pressure at preferably not less than 0.01 Pa, more preferably not less than 0.03 Pa, and preferably not more than 1 Pa, more preferably not more than 0.3 Pa. Further, a flow rate of each gas may be appropriately set so as to obtain a desired composition, and may be set to normally 0.1 to 100 sccm.

In manufacturing process of the reflective photomask blank, the substrate or the substrate and the film formed on the substrate may be heat-treated before forming the resist film. When the heat treatment is performed, it is preferable to perform the heat treatment in the state in which the surface of the light absorbing film is not exposed. As a method of the heat treatment, an infrared heating, a resistance heating or others can be applied, and conditions for the treatment are not particularly limited. The heat treatment may be performed, for example, under an atmosphere of a gas containing oxygen (O). The gas containing oxygen(O) has a concentration of, for example, 1 to 100 vol% in the case of oxygen gas (O$_2$ gas), however not particularly limited thereto. The heat treatment is performed at a temperature of preferably not less than 200 °C, more preferably not less than 400 °C.

In manufacturing process of the reflective photomask blank, before forming the resist film, the films excluding the light absorbing film that are formed on the substrate may be subjected to ozone treatment, or plasma treatment, and conditions for the treatment are not particularly limited. Each treatment may be carried out to increase oxygen concentration in the surface portion of the film. In this case, conditions for the treatment may be appropriately adjusted so as to obtain a predetermined oxygen concentration. In addition, in the case that the film is formed by sputtering, the oxygen concentration in the surface portion of the film can be increased also by adjusting a ratio of a rare gas, and a gas containing oxygen (oxidizing gas) such as oxygen gas (O$_2$ gas), carbon monoxide gas (CO gas), and carbon dioxide gas (CO$_2$ gas) in the sputtering gas.

In manufacturing process of the reflective photomask blank, before forming the resist film, a cleaning treatment may be performed to remove defects which present on the surface of the substrate or the film formed on the substrate. The cleaning can be performed with using either or both of ultrapure water and a functional water, which is ultrapure water containing ozone gas (O$_3$ gas), hydrogen gas (H$_2$ gas), or others. In the case that the cleaning treatment is performed to the light absorbing film, preferably, a functional water containing ozone gas (O$_3$ gas) is not used. Further, the cleaning may be performed by ultrapure water containing a surfactant, followed by cleaning with either or both of ultrapure water and the functional water. The cleaning may be performed while irradiating with ultrasonic wave, if need, and may be further performed with combining UV light irradiation.

A method of forming the resist film (applying the resist) is not particularly limited, and a known method such as spin coating may be applied.

From a reflective photomask blank of the invention, a reflective photomask including a substrate, a multilayer

EP 4 730 031 A2

reflection film, a protection film and a pattern of a light absorbing film can be manufactured.

In manufacturing the reflective photomask, when no resist film is formed in the reflective photomask blank, a resist film is formed in contact with the side remote from the substrate of the film remotest from the substrate of the reflective photomask blank, for example, the light absorbing film. After that, the reflective photomask can be manufactured by patterning the light absorbing film by dry etching using a chlorine-based gas containing oxygen, and a resist pattern obtained by patterning the resist film, as an etching mask. In manufacturing the reflective photomask, the resist pattern can be removed by a sulfuric acid-hydrogen peroxide mixture (SPM).

In particular, as a method for manufacturing a reflective photomask including the pattern of the light absorbing film from the reflective photomask blank of the invention, the following method is exemplified. First, if needed, a resist film is formed in contact with the light absorbing film at the side remote from the substrate (Step (A)). Next, the resist film is patterned to form a resist pattern (Step (B)). Next, the light absorbing film is patterned to form a pattern of the light absorbing film by dry etching using a chlorine-based gas, preferably dry etching using a chlorine-based gas containing oxygen, and the resist pattern as an etching mask (Step (C)). Next, and the resist pattern is removed (Step (D)).

EXAMPLES

Examples of the invention are given below by way of illustration and not by way of limitation.

Example 1

A reflective photomask blank as shown in FIG. 1 was manufactured by laminating a multilayer reflection film, a protection film and a light absorbing film in the order on a quartz substrate having dimensions of 152 mm square and about 6 mm thick.

First, the multilayer reflection film that was a laminated film (thickness: 280 nm) in which molybdenum (Mo) layers and silicon (Si) layers were alternately laminated and had a reflectance of 65% with respect to light having a wavelength of 13.5 nm was formed on the quartz substrate with using a molybdenum (Mo) target and a silicon (Si) target as targets, and argon gas (Ar gas) as a sputtering gas, by performing sputtering of the molybdenum (Mo) target and sputtering of the silicon (Si) target, alternately, with adjusting applied powers to the targets and a flow rate of the sputtering gas. The molybdenum (Mo) layers and the silicon (Si) layers were laminated for 40 cycles (40 molybdenum (Mo) layers and 40 silicon (Si) layers, respectively).

Next, a film composed of simple ruthenium (Ru) film (thickness: 2 nm) as the protection film was formed on the multilayer reflection film with using a ruthenium (Ru) target as a target, and argon gas (Ar gas) as a sputtering gas, by performing sputtering of the ruthenium (Ru) target with adjusting an applied power to the target and a flow rate of the sputtering gas.

Next, a light-absorbing film was formed on the protection film with using a ruthenium (Ru) target and a chromium (Cr) target as targets, and argon gas (Ar gas) as a sputtering gas, by sputtering with adjusting applied powers to the targets and flow rates of the sputtering gas. As a result, the reflective photomask blank was obtained.

In connection with the light absorbing film, compositions, thickness, and reflectance (relative reflectance to the multilayer reflection film and the protection film) and phase shift (relative phase shift to the multilayer reflection film and the protection film) with respect to light having a wavelength of 13.5 nm are shown in Table 1. The compositions of the light absorbing film were measured by an X-ray photoelectron spectrometer, and the same method was applied to the followings. The thickness of the light absorbing film was measured by an X-ray diffractometer, and the same method was applied to the followings. The reflectance was measured by a reflectometer with respect to light having an incident angle of 6 degrees, and the same method was applied to the followings. Furthermore, the refractive index n and extinction coefficient k were measured by a refractive index/extinction coefficient measuring instrument, and the phase shift was calculated from these measured values, and the same method was applied to the followings.

Examples 2 to 6 and Comparative Examples 1 to 9

A reflective photomask blank was obtained by forming the multilayer reflection film and the protection film in the same manner as in Example 1, and forming a light absorbing film in the same manner as in Example 1 except that one or more of the applied powers to the targets, the flow rates of the sputtering gases and a sputtering time were changed.

In Examples 5 and 6, and Comparative Example 8, a niobium (Nb) target was used along with the ruthenium (Ru) target and the chromium (Cr) target. In Comparative Example 1, the ruthenium target and the chromium (Cr) target were not used, and a tantalum (Ta) target was used. In Comparative Example 9, the chromium (Cr) target was not used, and a tantalum (Ta) target was used along with the ruthenium target. In Comparative Examples 1, 4, 6, 7 and 9, as the sputtering gases, nitrogen gas ($N_2$ gas) was used along with the argon gas (Ar gas). In Comparative Examples 5 and 6, as the sputtering gases, oxygen gas ($O_2$ gas) was used along with the argon gas (Ar gas). In connection with the light absorbing film, compositions and thickness, and reflectance and phase shift with respect to light having a wavelength of 13.5 nm are shown in Table 1.

Table 1

| | | Composition [at%] | | | | | | Thickness [nm] | Reflectance [%] | Phase Shift [degree] |
|---|---|---|---|---|---|---|---|---|---|---|
| | | Ru | Cr | Nb | Ta | O | N | | | |
| Example 1 | RuCr | 69 | 31 | 0 | 0 | 0 | 0 | 42 | 13.0 | 213 |
| Example 2 | RuCr | 71 | 29 | 0 | 0 | 0 | 0 | 42 | 13.7 | 213 |
| Example 3 | RuCr | 67 | 33 | 0 | 0 | 0 | 0 | 41 | 14.0 | 216 |
| Example 4 | RuCr | 68 | 32 | 0 | 0 | 0 | 0 | 42 | 12.6 | 213 |
| Example 5 | RuCrNb | 68 | 31 | 1 | 0 | 0 | 0 | 43 | 14.4 | 210 |
| Example 6 | RuCrNb | 68 | 30 | 2 | 0 | 0 | 0 | 43 | 14.9 | 210 |
| Comparative Example 1 | TaN | 0 | 0 | 0 | 60 | 0 | 40 | 68 | 1.7 | 180 |
| Comparative Example 2 | RuCr | 52 | 48 | 0 | 0 | 0 | 0 | 46 | 12.8 | 236 |
| Comparative Example 3 | RuCr | 78 | 22 | 0 | 0 | 0 | 0 | 51 | 14.7 | 247 |
| Comparative Example 4 | RuCrN | 67 | 26 | 0 | 0 | 0 | 7 | 46 | 19.7 | 237 |
| Comparative Example 5 | RuCrO | 68 | 27 | 0 | 0 | 5 | 0 | 52 | 14.2 | 256 |
| Comparative Example 6 | RuCrON | 67 | 25 | 0 | 0 | 4 | 4 | 48 | 12.9 | 256 |
| Comparative Example 7 | RuCrN | 32 | 65 | 0 | 0 | 0 | 3 | 35 | 6.8 | 174 |
| Comparative Example 8 | RuCrNb | 67 | 27 | 6 | 0 | 0 | 0 | 55 | 12.3 | 285 |
| Comparative Example 9 | RuTaN | 87 | 0 | 0 | 4 | 0 | 9 | 42 | 11.9 | 249 |

Using the resulting reflective photomask blank, a reflective photomask as shown in FIG. 2 was manufactured. First, a positive chemically amplified electron beam resist was spin-coated on the light absorbing film to form a resist film having a thickness of 150 nm.

Next, a line and space pattern (long side dimension: 1000 nm, 100000 line patterns) was drawn at a dose of 100 $\mu C/cm^2$ by an electron beam lithography apparatus. In connection with the widths of the line and space pattern, the widths of the line pattern were set to 13 different widths with changing at 2 nm intervals within the range of 48 to 72 nm, and the widths of the space patterns were set to 49 different widths with changing at 2 nm intervals within the range of 48 to 144 nm. The widths of the line and space pattern were changed in various combinations to form the line and space pattern.

Next, a heat treatment (PEB: Post Exposure Bake) was performed at 110° C for 14 minutes by a heat treatment apparatus. Next, a development process was performed for 40 seconds by paddle development to form a resist pattern. Next, dry etching using a chlorine-based gas containing oxygen was performed to the light absorbing film under the following conditions with using the obtained resist pattern as an etching mask, to form a light absorbing film pattern.

[Conditions for Dry Etching Using Chlorine-based Gas Containing Oxygen to Light Absorbing Film]

Apparatus: ICP (Inductively Coupled Plasma) System
Etching gas: $Cl_2$ gas and $O_2$ gas
Gas pressure: 3.0 mTorr (0.40 Pa)
ICP power: 350W

Next, the remaining resist pattern was removed by washing with a sulfuric acid-hydrogen peroxide mixture (a mixture of sulfuric acid and hydrogen peroxide (sulfuric acid/hydrogen peroxide=3/1 (volume ratio))) to obtain a reflective photomask.

NILS of the line and space pattern of the light absorbing film in the resulting reflective photomask was evaluated under the following conditions by a wafer transfer simulator capable of measuring gradient of aerial image. The wafer transfer simulator capable of measuring gradient of aerial image has an illumination system and a projection system that are almost equivalent to a wafer exposure apparatus, and can measure the gradient of aerial image of a specific pattern by irradiating exposure light to a minute region of the reflective photomask.

[Setting Conditions for Wafer Transfer Simulator]

NA (numerical aperture of wafer exposure apparatus): 0.33
Illumination conditions: Dipole
Simga-in: 0.7
Sigma-out: 0.9
Center angle: 0 degrees
Blade angle: 30 degrees
Wafer defocus: 0.03 $\mu$m

In connection with all line patterns and space patterns that were varied in the dimensions of the line patterns and space patterns, each NILS was evaluated in the resulting reflective photomask, and the maximum NILS value was evaluated. The NILS was calculated by the following expression:

$$NILS=(dI/dx)/(W \times Ith),$$

wherein W is a desired pattern dimension, Ith is a threshold of light intensity providing W, and dI/dx is a gradient of aerial image. The NILS (maximum value) and the difference to the NILS (maximum value) of Comparative Example 1 which corresponds to the case of a binary type reflective photomask are shown in Table 2.

Table 2

|  | NILS [maximum value] | Difference to Comparative Example 1 |
| --- | --- | --- |
| Example 1 | 2.93 | 0.34 |
| Example 2 | 2.85 | 0.26 |
| Example 3 | 2.88 | 0.29 |
| Example 4 | 2.81 | 0.22 |
| Example 5 | 2.80 | 0.21 |
| Example 6 | 2.78 | 0.19 |
| Comparative Example 1 | 2.59 | --- |
| Comparative Example 2 | 2.43 | -0.16 |
| Comparative Example 3 | 2.35 | -0.24 |
| Comparative Example 4 | 2.28 | -0.31 |
| Comparative Example 5 | 2.13 | -0.46 |
| Comparative Example 6 | 2.15 | -0.44 |
| Comparative Example 7 | 2.02 | -0.57 |
| Comparative Example 8 | 2.05 | -0.54 |
| Comparative Example 9 | 2.07 | -0.52 |

The invention is not limited to the above embodiment. The above-described embodiment is an example, and any other embodiments having the same or substantially the same configuration as the technical idea of the invention and having the same or similar effects can be regarded as the invention included in the scope of the inventive technical range.

**Claims**

1. A reflective photomask blank comprising

    a substrate,
    a multilayer reflection film that is formed on the substrate and reflects exposure light being light in extreme ultraviolet range,
    a protection film that is formed on the multilayer reflection film to protect the multilayer reflection film, and
    a light absorbing film that is formed on the protection film, absorbs the exposure light, and has a phase shift function, wherein

    the light absorbing film
    comprises ruthenium (Ru) and chromium (Cr) and is free of oxygen (O) and nitrogen (N), and
    has a ruthenium (Ru) content of not less than 64 at% and not more than 74 at%, a chromium (Cr) content of not less than 26 at% and not more than 36 at%,
    a thickness of not less than 40 nm and not more than 44 nm,
    a reflectance of not less than 12% and not more than 15% with respect to the exposure light, and a phase shift of not less than 200 degrees and not more than 230 degrees with respect to the exposure light.

2. The reflective photomask blank of claim 1 wherein the light absorbing film further comprises niobium (Nb), and has a niobium (Nb) content of not more than 4 at%.

3. The reflective photomask blank of claim 1 or 2 wherein the protection film has a thickness of not less than 1 nm and not more than 6 nm.

4. A method for manufacturing a reflective photomask comprising a pattern of the light absorbing film from the reflective photomask blank of any one of claims 1 to 3 wherein
    the method comprises the steps of:

    (A) forming a resist film in contact with the light absorbing film at the side remote from the substrate,
    (B) patterning the resist film to form a resist pattern,
    (C) patterning the light absorbing film to form a light absorbing film pattern by dry etching using a chlorine-based gas, and the resist pattern as an etching mask, and
    (D) removing the resist pattern.

# FIG.1

100

4
3
2
1

# FIG.2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022024617 A